# EUROPÄISCHE PATENTANMELDUNG

(11) **EP 2 161 124 A2**
(43) Veröffentlichungstag der Anmeldung: **10.03.2010**
(21) Anmeldenummer: 09168716.0
(22) Anmeldetag: 26.08.2009
(51) Int. Cl.: B32B 18/00

(54) **LTCC-Schichtstapel**

(30) Priorität: 09.09.2008 DE 102008046336
(71) Anmelder: Osram Gesellschaft mit beschränkter Haftung, 81543 München (DE)
(72) Erfinder: Karmazin, Roman, 80939, München (DE)

(57) **Zusammenfassung**

Der ungesinterte LTCC-Schichtstapel ist aus mehreren aufeinandergestapelten grünen Keramikschichten zusammengesetzt, von denen mindestens eine erste grüne Schicht Zirkonoxid als Hauptbestandteil und eine Beimischung mindestens eines Sinterhilfsmittels aufweist.

## Beschreibung

Die Erfindung betrifft einen ungesinterten LTCC-Schichtstapel, einen daraus gesinterten LTCC-Schichtstapel, ein keramisches Elektronikmodul mit dem gesinterten LTCC-Schichtstapel, einen monolithischen Transformator mit dem gesinterten LTCC-Schichtstapel und ein Verfahren zum Herstellen eines gesinterten LTCC-Schichtstapel.

Magnetischen Keramikmaterialien (Ferrite) wird üblicherweise ein niedriger Anteil an Sinterhilfsstoffen zugesetzt, um ihre Anwendung bei der LTCC ("Low Temperature Cofired Ceramics"; Niedertemperatur-Einbrand-Keramik)-Methode zu ermöglichen. Jedoch weisen kommerziell erhältliche Grundschichten (auch "Basistapes" genannt) einen wesentlich höheren Anteil an Sinterhilfsstoffen auf, wodurch sich ihr Sinterverhalten von dem der LTCC-Ferritmaterialien unterscheidet. Darüber hinaus zeigen die LTCC-Ferritmaterialien einen hohen Wärmeausdehnungskoeffizienten von 11-12 (10⁻⁶ K⁻¹) im Vergleich zu den kommerziell erhältlichen Grundschichten mit einem Wärmeausdehnungskoeffizienten von typischerweise 5 bis 6 (10⁻⁶ K⁻¹). Die Unterschiede im Sinterverhalten und in der Wärmeausdehnung führen zur Schichtablösung zwischen Grundschicht und magnetischer Schicht während des Sinterns oder zur Bildung von Spannungen in den Ferritlagen, wodurch sich deren magnetische Permeabilität verringert. Für eine volle Integration von magnetischen Keramikmaterialien in LTCC-Schichtstapeln wird daher eine neue Grundschicht benötigt, welche idealerweise die folgenden Randbedingungen zumindest annähernd erfüllt:
- Sintertemperatur Ts ≤ 1000 °C, insbesondere Ts ≤ 900 °C;
- Chemische Kompatibilität mit den Ferritmaterialien;
- Sinterverhalten kompatibel mit den Ferritmaterialien (keine Schichtablösung, nur unwesentliche Erzeugung von Spannungen in den Ferritlagen);
- Wärmeausdehnungskoeffizient zwischen 11 und 12 (10⁻⁶ K⁻¹);
- Permittivität ε ≤ 20.

Es ist die Aufgabe der vorliegenden Erfindung, eine Möglichkeit zur Schaffung von keramischen LTCC-Schichtstapeln mit magnetischen Keramikschichten bereitzustellen, bei denen sich die magnetischen Schichten schwerer als bisher während des Sinterns lösen und / oder nach dem Sintern eine geringere Eigenspannung aufweisen.

Diese Aufgabe wird mittels eines ungesinterten LTCC-Schichtstapels, eines daraus gesinterten LTCC-Schichtstapels, eines keramischen Elektronikmoduls, eines monolithischen Transformator und eines Verfahrens zum Herstellen eines gesinterten LTCC-Schichtstapels gelöst. Bevorzugte Ausführungsformen sind insbesondere den abhängigen Ansprüchen entnehmbar.

Der ungesinterte LTCC-Schichtstapel weist mehrere aufeinandergestapelte grüne (d. h., vorgeformte, z. B. gepresste oder gegossene, aber noch nicht gesinterte) Keramikschichten auf, von denen mindestens eine erste Keramikschicht Zirkonoxid (ZrO₂) als Hauptbestandteil und eine Beimischung mindestens eines Sinterhilfsmittels aufweist. Als Keramikschichten werden häufig sog. "tapes" verwendet.

Zirkonoxid weist beispielsweise in seiner tetragonalen Form einen Wärmeausdehnungskoeffizienten zwischen 11 und 12 (10⁻⁶ K⁻¹) und eine Permittivität ε zwischen 20 und 25 auf. Allerdings beträgt die Sintertemperatur von Zirkonoxid ca. 1500 °C bis 1700 °C. Durch die Beimischung des mindestens einen Sinterhilfsmittels wird die Sintertemperatur unter Beibehaltung des Werts der Permittivität ε stark auf unter 900 °C gesenkt. Eine solche Mischung aus Zirkonoxid und Sinterhilfsmittel(n) ist ferner chemisch und im Sinterverhalten kompatibel mit typischen keramischen Ferritmaterialien.

Es wird ein ungesinterter LTCC-Schichtstapel bevorzugt, bei dem die mindestens eine erste grüne Keramikschicht eine Beimischung von Bismutoxid (auch Wismutoxid genannt) als Sinterhilfsmittel aufweist.

Alternativ oder zusätzlich wird ein ungesinterter LTCC-Schichtstapel bevorzugt, bei dem die mindestens eine erste grüne Keramikschicht eine Beimischung von Siliziumoxid (SiO₂) als Sinterhilfsmittel aufweist, insbesondere quarzartigem Siliziumoxid.

Jedoch sind die Sinterhilfsmittel nicht darauf beschränkt. So können z. B. auch andere Oxidkeramiken oder Glasfritt verwendet werden.

Es wird ein ungesinterter LTCC-Schichtstapel bevorzugt, bei dem mindestens eine andere grüne Keramikschicht eine grüne Ferritkeramikschicht umfasst. Bevorzugte Ferritmaterialien umfassen MnZn, aber es könnten auch Ferrite mit NiZn oder NiZnCu verwendet werden. Allgemein sind magnetische, insbesondere weichmagnetische, Keramiken, insbesondere spinelförmige Ferrite, einsetzbar.

Es wird bevorzugt, wenn der prozentuale Volumenanteil des bzw. der Sinterhilfsmittel(s), insbesondere von Bismutoxid oder von Bismutoxid und Siliziumoxid zusammen, einen Wert von 20 Vol-% nicht überschreitet, speziell 15 Vol-% nicht überschreitet und insbesondere in einem Bereich um 10 V0ol-% liegt.

Es wird ferner bevorzugt, wenn Bismutoxid einen höheren prozentualen Molanteil als Siliziumoxid aufweist.

Es kann ein ungesinterter LTCC-Schichtstapel bevorzugt sein, bei dem das Zirkonoxid ein tetragonales Zirkonoxid (t-ZrO₂) ist.

Es kann aber auch ein ungesinterter LTCC-Schichtstapel bevorzugt sein, bei dem bei dem das Zirkonoxid kubisches Zirkonoxid (c-ZrO₂) ist.

Es wird ein ungesinterter LTCC-Schichtstapel bevorzugt, bei dem das Zirkonoxid ein mit 0 Mol-% bis 15 Mol% Yttriumoxid (Y₂O₃) stabilisiertes bzw. dotiertes Zirkonoxid ist, insbesondere mit einem Yttriumoxidanteil zwischen 1 Mol-% und 10 Mol-% Yttriumoxid, speziell zwischen 3 Mol-% und 8 Mol-% Yttriumoxid. Es werden insbesondere ein mit 3 Mol-% Yttriumoxid stabilisiertes tetragonales Zirkonoxid (3YTZ), ein 3YTZ mit geringerer spezifischer Oberfläche (z. B. 7 ± 2 m2/g statt 16 ± 3 m2/g) (3YTZ-S) oder ein mit 8 Mol-% Yttriumoxid stabilisiertes kubisches Zirkonoxid (8YTZ) bevorzugt, alle kommerziell erhältlich von der Firma TOSOH, Japan. Besonders bevorzugt wird ein mit 6 bis 10 Mol-% Yttriumoxid vollstabilisiertes (kubisches) c-ZrO₂. Jedoch ist stabilisiertes Zirkonoxid nicht auf eine Stabilisierung durch Yttriumoxid beschränkt; vielmehr können zusätzlich oder alternativ z. B. Oxide mit Ce3+, Ca2+, Mg2+, Sm3+ und viele weitere Oxide zur Stabilisierung des ZrO₂, insbesondere c-ZrO₂, verwendet werden.

Es wird ein ungesinterter LTCC-Schichtstapel bevorzugt, bei dem eine erste Keramikschicht eine Grundschicht (Basistape) ist, auf der mindestens eine grüne magnetische Keramikschicht aufgestapelt ist. Jedoch ist der LTCC-Schichtstapel nicht darauf beschränkt. So können zusätzlich oder alternativ ein oder mehrere Zirkonoxid-basierte Schichten zwischen Ferritschichten eingefügt liegen. Die mindestens eine erste Keramikschicht kann somit eine Zwischenschicht sein, die zwischen grünen magnetischen Keramikschichten eingefügt ist; dadurch wird ein dielektrischer Spalt zwischen den Ferritschichten geschaffen.

Bevorzugt wird eine Schichtdicke der Ferritschichten zwischen 0,1 mm und 3 mm, bei dazwischen eingefügter Zirkonoxidbasierter Schicht zwischen 1 - 2 mm je Ferritschicht. Die Dicke der Zirkonoxid-basierten Schicht liegt vorzugsweise ebenfalls zwischen 0,1 und 3 mm, bei zwischen Ferritschichten eingefügter Zirkcnoxid-basierter Schicht zwischen 0,4 mm und 1,0 mm.

Der gesinterte LTCC-Schichtstapel wird durch Sintern eines solchen ungesinterten LTCC-Schichtstapels hergestellt. Dabei kann können die Sinterhilfsmittel (Bi203, Si02 usw.) während des Sinterns mit dem (voll- oder teil-)stabilisierten oder unstabilisierten Zirkonoxid in einen Mischkristall umgewandelt werden.

Es wird ein gesinterter LTCC-Schichtstapel bevorzugt, bei dem das Sintern bei einer Sintertemperatur von 1000 °C oder weniger durchgeführt wurde, insbesondere bei einer Sintertemperatur von 900 °C oder weniger.

Das Verfahren zum Herstellen eines LTCC-Schichtstapels weist mindestens die folgenden Schritte auf: (a) Herstellen eines ungesinterten LTCC-Schichtstapels wie oben beschrieben; und (b) Sintern des ungesinterten LTCC-Schichtstapels, insbesondere bei einer Sintertemperatur von 900 °C oder weniger.

In den folgenden Figuren wird die Erfindung anhand von Ausführungsbeispielen schematisch genauer beschrieben.
- FIG 1: skizziert als Schnittdarstellung in Seitenansicht einen LTCC-Schichtstapel mit Zirkonoxid-basierten Deckschichten und dazwischen liegenden Ferritkeramikschichten;
- FIG 2: zeigt eine Auftragung eines Realteils µ' einer komplexen magnetischen Permeabilität gegen eine Mess-frequenz in Hz für gesinterte LTCC-Schichtstapel der Struktur nach FIG 1 mit verschiedenen Materialien der Zirkonoxid-basierten Schichten.

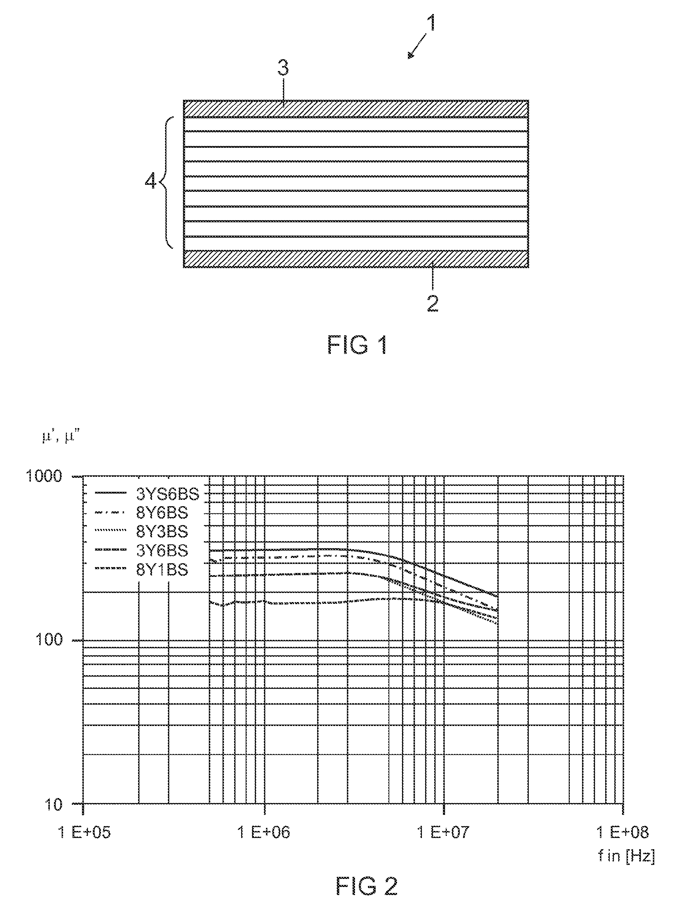

FIG 1 zeigt einen LTCC-Schichtstapel 1, welcher eine untere Deckschicht (Grundschicht bzw. Basistape) 2 und eine obere Deckschicht 3 gleicher Dicke mit Zirkonoxid als Hauptbestandteil und eine Beimischung eines Sinterhilfsmittels in Form einer Mischung von Bismutoxid und Siliziumoxid aufweist, wobei zwischen den Deckschichten 2,3 neun keramische Ferritlagen 4 angeordnet sind.

FIG 2 zeigt eine Auftragung eines Realteils µ' einer komplexen magnetischen Permeabilität gegen eine Messfrequenz in Hz für verschiedene gesinterte LTCC-Schichtstapel. Die Messungen wurden mit einem Impedanzmessgerät HP 4194A der Fa. Hewlett-Packard, USA, durchgeführt. Die LTCC-Schichtstapel wiesen jeweils eine untere Deckschicht (Grundschicht bzw. Basistape) und eine obere Deckschicht auf, die mit Zirkonoxid als Hauptbestandteil gesintert worden sind, wobei zwischen den Deckschichten neun keramische Ferritlagen angeordnet sind. Im Einzelnen wurden Deckschichten mit folgenden Materialzusammensetzungen verwendet:
a) 3YZT-S mit 10 Vol-% einer Beimischung von Bismutoxid und Siliziumoxid als Sinterhilfsmittel in einem molaren Verhältnis Bi₂O₃ : SiO₂ von 6 : 1 bzw. deren Sinterprodukt [3YS6BS] mit einem Wert des Realteils µ' von maximal 375;
b) 8YZT mit 10 Vol-% einer Beimischung von Bismutoxid und Siliziumoxid in einem molaren Verhältnis Bi₂O₃ : SiO₂ von 6 : 1 bzw. deren Sinterprodukt [8Y6BS] mit einem Wert des Realteils µ' von maximal 341;
c) 8YZT mit 10 Vol-% einer Beimischung von Bismutoxid und Siliziumoxid in einem molaren Verhältnis Bi₂O₃ : SiO₂ von 3 : 1 bzw. deren Sinterprodukt [8Y3BS] mit einem Wert des Realteils µ' von maximal 266;
d) 3YZT mit 10 Vol-% einer Beimischung von Bismutoxid und Siliziumoxid in einem molaren Verhältnis Bi₂O₃ : SiO₂ von 6 : 1 bzw. deren Sinterprodukt [3Y6BS] mit einem Wert des Realteils µ' von maximal 262; und
e) 8YZT mit 10 Vol-% einer Beimischung von Bismutoxid und Siliziumoxid in einem molaren Verhältnis Bi₂O₃ : SiO₂ von 1 : 1 bzw. deren Sinterprodukt [8Y1BS] mit einem Wert des Realteils µ' von maximal 177.

Alle Schichtstapel weisen in einem vorderen Frequenzbereich zwischen 500 KHz und ca. 3 MHz einen im Wesentlichen konstanten Wert des Realteils µ' auf, der zu höheren Frequenzen hin abfällt. Nur der Schichtstapel mit 8Y1BS fällt später ab, und zudem schwächer als die anderen Schichtstapel.

Der Schichtstapel mit 3YS6BS in den Deckschichten zeigt den stärksten Wert des Permeabilität-Realteils µ' aller untersuchten Materialzusammensetzungen, und zwar über den gesamten Frequenzbereich, gefolgt von 8Y6BS und 8Y3BS. Der Schichtstapel mit 3Y6BS zeigt im Frequenzbereich zwischen 500 KHz und ca. 5 MHz ungefähr den gleichen Wert für µ' wie derjenige mit 8Y3BS, fällt bei höheren Frequenzen aber stärker ab als 8Y3BS. Zumindest bis 10 MHz zeigt der Schichtstapel mit 8Y1BS in den Deckschichten den geringsten Wert von µ'. Insbesondere die Schichtstapel mit einem Wert für µ' von anfänglich über 300, nämlich mit 3YS6BS oder 8Y6BS, sind zur Verwendung in keramischen Elektronikmodulen besonders geeignet.

Weitere, hier nicht dargestellte, rasterelektronenmikroskopische Untersuchungen zusammen mit energiedispersiven röntgenspektroskopischen Untersuchungen an den gesinterten LTCC-Schichtstapeln zeigten, dass an der Grenzfläche zwischen den Deckschichten und den benachbarten Ferritschichten eine gute Haftung (keine Schichtablösung) vorlag, keine Diffusion zwischen den Schichten auftrat und keine chemische Reaktion zwischen den Materialien den Schichten auftrat.

Eine bevorzugte Anwendung liegt in der Beleuchtungstechnik.

Selbstverständlich ist die vorliegende Erfindung nicht auf die gezeigten Ausführungsbeispiele beschränkt.

### Bezugszeichenliste

1 LTCC-Schichtstapel
2 untere Deckschicht
3 obere Deckschicht
4 keramische Ferritlage

## Patentansprüche

1. Ungesinterter LTCC-Schichtstapel (1) mit mehreren aufeinandergestapelten grünen Keramikschichten (2,3,4), von denen mindestens eine erste grüne Keramikschicht (2,3) Zirkonoxid als Hauptbestandteil und eine Beimischung mindestens eines Sinterhilfsmittels aufweist.

2. Ungesinterter LTCC-Schichtstapel (1) nach Anspruch 1, bei dem die mindestens eine erste grüne Keramikschicht (2,3) eine Beimischung von Bismutoxid als Sinterhilfsmittel aufweist.

3. Ungesinterter LTCC-Schichtstapel (1) nach Anspruch 1 oder 2, bei dem die mindestens eine erste grüne Keramikschicht (2,3) eine Beimischung von Siliziumoxid als Sinterhilfsmittel aufweist.

4. Ungesinterter LTCC-Schichtstapel (1) nach einem der Ansprüche 1 bis 3, bei dem das Zirkonoxid tetragonales Zirkonoxid ist.

5. Ungesinterter LTCC-Schichtstapel (1) nach einem der Ansprüche 1 bis 3, bei dem das Zirkonoxid kubisches Zirkonoxid ist.

6. Ungesinterter LTCC-Schichtstapel (1) nach einem der vorhergehenden Ansprüche, bei dem das Zirkonoxid ein mit 0 Mol-% bis 15 Mol-% Yttriumoxid stabilisiertes Zirkonoxid ist, insbesondere mit einem Yttriumoxidanteil zwischen 1 Mol-% und 10 Mol-% Yttriumoxid, speziell mit 6 Mol-% bis 10 Mol-% Yttriumoxid stabilisiertes kubisches Zirkonoxid.

7. Ungesinterter LTCC-Schichtstapel (1) nach einem der vorhergehenden Ansprüche, bei dem eine erste Keramikschicht (2) eine Grundschicht ist, auf der mindestens eine grüne magnetische Keramikschicht (4) aufgestapelt ist.

8. Ungesinterter LTCC-Schichtstapel nach einem der vorhergehenden Ansprüche, bei dem mindestens eine erste Keramikschicht eine Zwischenschicht ist, die zwischen grünen magnetischen Keramikschichten eingefügt ist.

9. Gesinterter LTCC-Schichtstapel, der durch Sintern eines ungesinterten LTCC-Schichtstapels (1) nach einem der vorhergehenden Ansprüche hergestellt worden ist.

10. Gesinterter LTCC-Schichtstapel nach Anspruch 9, bei dem das Sintern bei einer Sintertemperatur von 1000 °C oder weniger durchgeführt wurde, insbesondere bei einer Sintertemperatur von 900 °C oder weniger.

11. Keramisches Elektronikmodul mit einem gesinterten LTCC-Schichtstapel nach Anspruch 9 oder 10.

12. Monolithischer Transformator mit einem gesinterten LTCC-Schichtstapel nach Anspruch 9 oder 10, insbesondere zur Verwendung mit einem keramischen Elektronikmodul.

13. Verfahren zum Herstellen eines LTCC-Schichtstapels, das mindestens die folgenden Schritte aufweist:
- Herstellen eines ungesinterten LTCC-Schichtstapels (1) nach einem der Ansprüche 1 bis 8; und
- Sintern des ungesinterten LTCC-Schichtstapels (1), insbesondere bei einer Sintertemperatur von 900 °C oder weniger.
